(19) Europäisches Patentamt
European Patent Office
Office européen des brevets

(11) **EP 3 203 409 A1**

(12) **EUROPEAN PATENT APPLICATION**
published in accordance with Art. 153(4) EPC

(43) Date of publication:
**09.08.2017  Bulletin 2017/32**

(51) Int Cl.:
***G06K 9/00*** *(2006.01)*

(21) Application number: **14902933.2**

(22) Date of filing: **23.12.2014**

(86) International application number:
**PCT/CN2014/094725**

(87) International publication number:
**WO 2016/049984 (07.04.2016 Gazette 2016/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **29.09.2014  CN 201410515656**

(71) Applicant: **Shenzhen Huiding Technology Co., Ltd.**
**Shenzhen, Guangdong 518000 (CN)**

(72) Inventor: **CHEN, Songtao**
**Shenzhen**
**Guangdong 518000 (CN)**

(74) Representative: **Stuttard, Garry Philip**
**Urquhart-Dykes & Lord LLP**
**Arena Point**
**Merrion Way**
**Leeds LS2 8PA (GB)**

(54) **FINGERPRINT IDENTIFICATION DEVICE AND METHOD**

(57)     The present invention discloses a fingerprint identification apparatus and method. The fingerprint identification apparatus comprises a fingerprint acquisition module, an analog-to-digital conversion module and a control module that are sequentially connected, wherein the analog-to-digital conversion module comprises a quantified voltage generator for generating a quantified voltage, the fingerprint acquisition module is configured to acquire fingerprint information, and the analog-to-digital conversion module is configured to perform an analog-to-digital conversion for the fingerprint information and output quantified fingerprint information data; wherein the control module is configured to control the quantified voltage generator to adjust an output range of the quantified voltage according to a distribution range of the fingerprint information data to enlarge a distribution range of the quantified fingerprint information data. As such, dynamic adjustment of the contrast of a fingerprint image is achieved with a simple circuit and a low cost. By improving dots per inch of analog-to-digital conversion of the fingerprint information, the contrast and signal-to-noise ratio of gray information of the fingerprint image are improved, and the identification rate of fingerprint identification is finally improved.

FIG. 3

**Description**

**TECHNICAL FIELD**

The present invention relates to the technical field of communications, and in particular, relates to a fingerprint identification apparatus and a fingerprint identification method.

**BACKGROUND**

The finger lines of people have differences in terms of depth. A convex place is called a "ridge", and a concave place is called a "valley". A capacitive fingerprint identification apparatus converts image information of "ridges" and "valleys" into a corresponding electrical signal by using a principle that induction capacitances corresponding to the "ridges" and the "valleys" included in the fingerprints are different, and thus amplitudes of the output signals are also different under incentive of the same alternating current signal.

With respect to the capacitive fingerprint identification apparatus, in which a fingerprint sensing unit serves as a basic unit, the fingerprint sensing unit extracts a capacitance coupling signal of each pixel point, transmits the signal to other parts of the fingerprint identification apparatus for such operations as amplification, analog-to-digital conversion, and image splicing, and then extracts effective fingerprint information. To prevent a sensor of the fingerprint identification apparatus from suffering electrostatic damages during the repeated touches, and to improve the mechanical strength, a non-conductive thick dielectric cover needs to be disposed on the surface of the sensor. Therefore, a coupling capacitance between a finger and the fingerprint sensing unit is small. In addition, since the depths of the fingerprints are small, the capacitance differences corresponding to the "ridges" and the "valleys" are also small, and the difference information of this part generally accounts for 1% to 3% of quantized fingerprint information data.

Therefore, how to increase a distribution range of the fingerprint information data, and further enlarge a proportion of the difference information between the "ridges" and the "valleys" in the quantized fingerprint information data, that is, to improve the contrast of "ridge" and "valley" images, is critical for improving the identification rate of the fingerprint identification.

Chinese Patent Application No. 200510063872.3 has disclosed a method for implementing a fingerprint sensor by using a charge amplifier. In this application, a polar plate of a fingerprint sensing unit needs to be made from a strain film material, and a relative capacitance variation of two layers of stain film is acquired by using the pressure of the depths of fingerprint during the touch. However, the cost of the strain film material is high in terms of process and manufacture, and thus the fingerprint sensor herein is difficult to achieve.

**SUMMARY**

A major objective of the present invention is to provide a fingerprint identification method and apparatus, in order to increase the contrast of a fingerprint image with a low cost and further improve the identification rate of fingerprint identification.

To this end, the present invention provides a fingerprint identification apparatus, comprising a fingerprint acquisition module, an analog-to-digital conversion module and a control module that are sequentially connected, wherein the analog-to-digital conversion module comprises a quantized voltage generator for generating a quantized voltage, the fingerprint acquisition module is configured to acquire fingerprint information, and the analog-to-digital conversion module is configured to perform an analog-to-digital conversion for the fingerprint information and output quantized fingerprint information data; wherein the control module is configured to control the quantized voltage generator to adjust an output range of the quantized voltage according to a distribution range of the fingerprint information data to enlarge a distribution range of the quantized fingerprint information data.

Preferably, the fingerprint identification apparatus further comprises a common mode voltage generation circuit respectively connected to the fingerprint acquisition module and the analog-to-digital conversion module, wherein the common mode voltage generation circuit is configured to coordinate a common mode level of an output signal of the fingerprint acquisition module with a common mode level of an input signal of the analog-to-digital conversion module.

Preferably, the fingerprint acquisition module comprises a fingerprint sensing unit, a signal amplifier and a signal enhancement unit that are sequentially connected, wherein the signal enhancement unit is connected to the analog-to-digital conversion module.

Preferably, the analog-to-digital converter is a ramp analog-to-digital converter, and the quantized voltage generator is a ramp generator.

Preferably, the quantized voltage generator outputs a single-end signal or a differential signal.

Preferably, the analog-to-digital converter is a pipelined analog-to-digital converter or a successive approximation analog-to-digital converter.

The present invention further provides a fingerprint identification method, comprising:

acquiring fingerprint information and outputting the fingerprint information by a fingerprint acquisition module to an analog-to-digital conversion module;

generating a quantized voltage to perform an analog-to-digital conversion for the fingerprint information and outputting quantized fingerprint information data by the analog-to-digital conversion module to a control module;

sending a quantized voltage adjustment signal by the control module to the analog-to-digital conversion module according to a distribution range of the fingerprint information data; and

adjusting an output range of the quantized voltage by the analog-to-digital conversion module according to the quantized voltage adjustment signal.

Preferably, while the fingerprint acquisition module outputs the fingerprint information to the analog-to-digital conversion module, the method further comprises:

coordinating a common mode level of an output signal of the fingerprint acquisition module with a common mode level of an input signal of the analog-to-digital conversion module by a common mode voltage generation circuit.

Preferably, the analog-to-digital conversion module generates the quantized voltage by using a quantized voltage generator.

Preferably, the analog-to-digital module is a ramp analog-to-digital converter, a pipelined analog-to-digital converter or a successive approximation analog-to-digital converter.

According to the fingerprint identification apparatus provided by the present invention, a quantized voltage range of the analog-to-digital converter is adjusted according to currently received fingerprint information data, and a distribution range of subsequent fingerprint information data is enlarged, thereby achieving dynamic adjustment of the contrast of a fingerprint image. By improving dots per inch of analog-to-digital conversion of the fingerprint information, the contrast and signal-to-noise ratio of gray information of the fingerprint image are improved. In addition, the common mode voltage generation circuit coordinates a common mode level of the output signal of the signal enhancement unit of the fingerprint acquisition module with a common mode level of the input signal of the analog-to-digital conversion module, such that the swing of a fingerprint detection signal reaches a maximum signal swing and the signal swing does not exceed but is closest to the size of an adjusted quantization window, and such that the analog-to-digital conversion module operates in an optimal state. The fingerprint identification apparatus according to the present invention increases the proportion of differential information between "ridges" and "valleys" in the quantized data of the fingerprint information. To be specific, the contrast of "ridges" and "valleys" images is enhanced, the imaging quality is notably improved, and finally the identification rate of subsequent fingerprint identification is improved.

The fingerprint identification apparatus according to the present invention has the following advantages: The circuit is simple and the implementation cost is low, and since the realization and operating state of the fingerprint sensing unit are not changed, the imaging consistency is ensured; no dielectric layer having special properties is needed, and the adaptability of the sensor is improved; the adjustment of the quantized voltage is associated with the distribution of the fingerprint information data, dynamic adjustment may be achieved, the adjustment is relatively flexible, and the interference to common mode information between the "ridges" and "valleys" may be prevented to the greatest extent; any analog-to-digital converter structure may be implemented, and therefore the adaptability is good; and the processing speed is high, and thus the imaging frame rate of the fingerprint identification apparatus may not be lowered.

**BRIEF DESCRIPTION OF THE DRAWINGS**

FIG. 1 is a structural block diagram illustrating a fingerprint identification apparatus according to a first embodiment of the present invention;

FIG. 2 is a structural block diagram of a fingerprint acquisition module according to an embodiment of the present invention;

FIG. 3 is a schematic diagram illustrating circuit connection of the fingerprint identification apparatus in FIG. 1;

FIG. 4 is a schematic diagram illustrating principles of the fingerprint identification apparatus according to embodiments of the present invention;

FIG. 5 is a structural block diagram illustrating a fingerprint identification apparatus according to a second embodiment of the present invention;

FIG. 6 is a schematic diagram illustrating circuit connection of the fingerprint identification apparatus in FIG. 5;

FIG. 7 is a flowchart illustrating a fingerprint identification method according to a first embodiment of the present invention; and

FIG. 8 is a flowchart illustrating a fingerprint identification method according to a second embodiment of the present invention.

The attainment of the objectives, functional features and advantages of the present invention are further described hereinafter with reference to the specific embodiments and the accompanying drawings.

## DETAILED DESCRIPTION

It should be understood that the embodiments described herein are only exemplary ones for illustrating the present invention, and are not intended to limit the present invention.

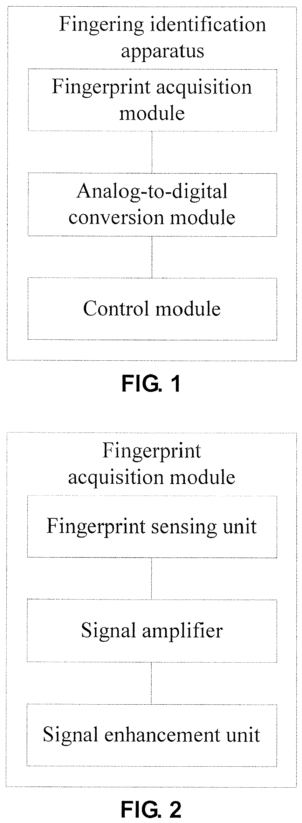

Referring to FIG. 1 to FIG. 3, a first embodiment of the present invention provides a fingerprint identification apparatus, the fingerprint identification apparatus comprises a fingerprint acquisition module, an analog-to-digital conversion module and a control module that are sequentially connected.

The fingerprint acquisition module is configured to acquire fingerprint information. As illustrated in FIG. 2, the fingerprint acquisition module comprises a fingerprint sensing unit, a signal amplifier and a signal enhancement unit (or referred to as a noise shaping and signal enhancement unit) that are sequentially connected. The fingerprint sensing unit is configured to acquire fingerprint information. The signal amplifier is configured to amplify the acquired fingerprint information. The signal enhancement unit is configured to perform noise shaping, signal-to-noise ratio promotion and the like for the fingerprint information. The signal enhancement unit includes, but not limited to, the following common functional circuits: a variable gain amplifier, an integrator, a low-pass filter and a sampling retaining circuit, and a signal link formed thereby.

The analog-to-digital conversion module is configured to perform an analog-to-digital conversion for the fingerprint information to convert the fingerprint information from an analog signal to a digital signal. The analog-to-digital conversion process is a quantization process. The analog-to-digital conversion module sends the quantized information data to the control module. The analog-to-digital conversion module comprises a quantized voltage generator, the quantized voltage generator is configured to generate a quantized voltage for the analog-to-digital conversion of the fingerprint information, and the quantized voltage generator may output a single-end signal or a differential signal. The type of the analog-to-digital conversion module is not limited, which may be a pipelined analog-to-digital converter, a successive approximation analog-to-digital converter or the like, and preferably a ramp analog-to-digital converter. The quantized voltage generator corresponds to a ramp generator. The ramp analog-to-digital converter has a small area, which may be simply practiced and has good linearity.

The control module may be a micro control unit (MCU), and configured to perform algorithm-based processing for the quantized fingerprint information, to finally implement fingerprint identification or detection functions or the like. The control module according to the present invention is further configured to control the quantized voltage generator to adjust an output range of the quantized voltage according to a distribution range of the currently received fingerprint information data, to enlarge a distribution range of the quantized fingerprint information data and to thus improve the contrast of a fingerprint image. To be specific, the control module performs the algorithm-based processing for the fingerprint information according to the distribution characteristics of the currently received fingerprint information data such as the distribution range or the like, and outputs a control signal to the quantized voltage generator, and moreover, controls the quantized voltage generator to generate different quantized reference voltages and adjust the output range of the quantized voltage. As such, FS and LSB of the analog-to-digital converter may be dynamically changed, and finally the dynamic adjustment function of the contrast of the fingerprint image may be implemented in the fingerprint identification apparatus. The FS refers to an amplitude of an effective full-scale input signal, and LSB refers to a least significant bit output by the analog-to-digital converter, which is equal to $FS/2^N$, wherein N represents the number of bits of the analog-to-digital converter.

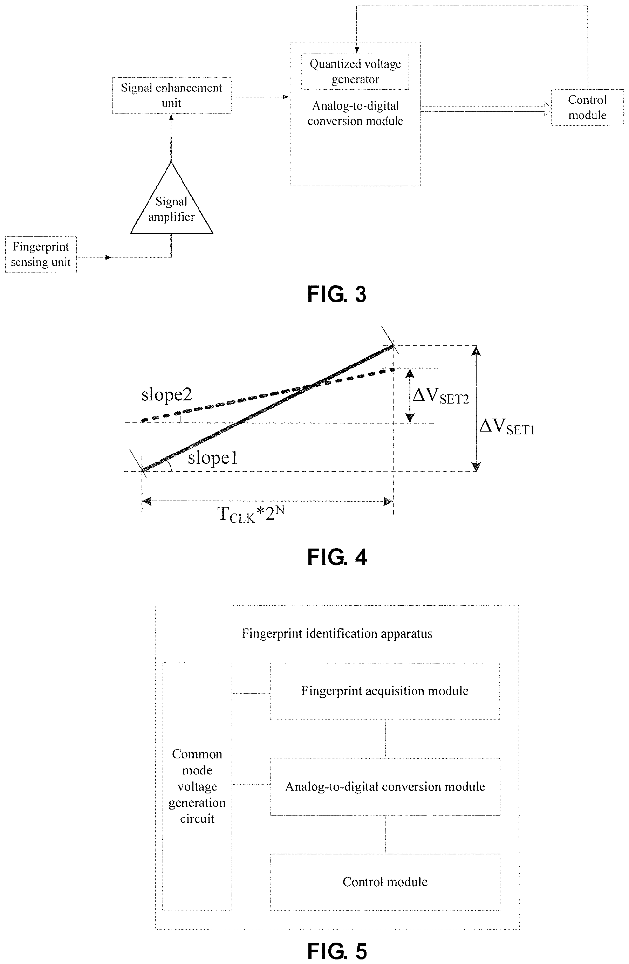

FIG. 3 illustrates a circuit connection diagram of the fingerprint identification apparatus in this embodiment. The fingerprint sensing unit, the signal amplifier, the signal enhancement unit, the analog-to-digital conversion module and the control module are sequentially connected; the control module and the quantized voltage generator in the analog-to-digital conversion module form a dynamic contrast adjustment loop. When a finger touches the surface of a sensor of the fingerprint identification apparatus, the fingerprint sensing unit outputs sampling information of the finger lines, that is, the fingerprint information, and then the signal amplifier amplifies the fingerprint information and outputs the fingerprint information to the subsequent signal enhancement unit, for performing further noise suppression, signal-to-noise ratio promotion and the like. In addition, a common mode level of the signal is converted according to the actual needs for facilitating subsequent processing. The fingerprint signal subjected to processing by the signal enhancement unit is transmitted to the analog-to-digital conversion module. The analog-to-digital conversion module converts the fingerprint signal and outputs a digital codeword signal ADC_OUT<N:1>, that is, the quantized fingerprint information. Furthermore, the control module performs further algorithm-based processing for the fingerprint information, thereby finally achieving the fingerprint identification or detection functions or the like.

In the present invention, to achieve sufficient dots per inch (DPI), generally an m*k array formed by fingerprint sensing units senses the finger lines information, the data obtained upon one-time quantization of outputs of all the m*k fingerprint sensing units is referred to as a frame of fingerprint information. In the technical solution according to the present invention, the control module may generate a quantized voltage adjustment signal according to the distribution range of a previous frame of fingerprint information data, such that an output range of the quantized voltage of the quantized voltage generator in the analog-to-digital conversion module is changed, and then under control of the control module, sampling of a next frame of fingerprint information is performed for the same finger.

For example:

Assume that an initial analog-to-digital conversion reference voltage of the analog-to-digital conversion module is V1 and a quantization window corresponding thereto is [V0-V1, V0+V1], then the voltage of the fingerprint information distributed within the quantization window may be quantized to data within the range of 0 to 10000, that is, starting from a lowest convertible voltage "V0-V1", each time the quantized data is increased by 1, the corresponding initial signal voltage before the conversion is increased by (2•V1)/1000. Still assume that for the fingerprint information acquired upon a finger press action, the distribution range of the quantized fingerprint information data is 5500 to 7000, and the voltage corresponding to the initial fingerprint information, that is, the quantized voltage signal range, is

$$[(V_0 - V_1) + (5500 \bullet \frac{2 \cdot V_1}{10000})] \sim [(V_0 - V_1) + (7000 \bullet \frac{2 \cdot V_1}{10000})].$$

The above result may be simplified to $[(V_0 + \frac{1 \cdot V_1}{10}] \sim [(V_0 + \frac{4 \cdot V_1}{10}]$. Before the fingerprint information acquired again by the same portion of the finger is quantized, the quantization window may be adjusted to [V0, V0+0.5*V1], that is, slightly greater than the voltage distribution range of the electric signal corresponding to the actual fingerprint information. Since the two relationships $\dfrac{(V_0 + \frac{1}{10} \bullet V_1) - V_0}{(V_0 + 0.5 \bullet V_1) - V_0} = \dfrac{1}{5}$ and $\dfrac{(V_0 + \frac{4}{10} \bullet V_1) - V_0}{(V_0 + 0.5 \bullet V_1) - V_0} = \dfrac{4}{5}$ are established, the distribution ranges of the quantized fingerprint information data is 2000 to 8000, that is, the distribution range of the secondarily quantized data for the same fingerprint information is increased to 4 times before the adjustment.

Accordingly, the range of the quantized voltage is negatively correlated to the distribution range of the fingerprint information data, and the distribution range of the fingerprint information may be increased by narrowing the range of the quantized voltage by a specific amplitude, to further improve the contrast of the fingerprint image. If the output range of the quantized voltage of the quantized voltage generator in the analog-to-digital conversion module is narrowed to 1/X of the original range, the contrast of the obtained second frame of fingerprint information is improved to $\log_2(X)$ times the contrast of the first frame of fingerprint information. Generally, the signal-to-noise ratio is also accordingly improved to $\log_2(X)$ times that of the first frame. Therefore, the imaging quality is significantly optimized.

A theoretic basis of improving the contrast is described hereinafter with reference to FIG. 4. Using the scenario where the analog-to-digital conversion module is a ramp analog-to-digital converter and the quantized voltage generator thereof is a ramp generator as an example, assume that during acquisition of the first frame of fingerprint information, the output range of the quantized voltage of the ramp generator in the ramp analog-to-digital converter is $\Delta V_{SET1}$, then a signal obtained after subsequent signal amplification and enhancement of the fingerprint information sensed by a fingerprint sensing unit A is marked as $V_{INXA}$, and a digital codeword obtained after an analog-to-digital conversion of the fingerprint information sensed by the fingerprint sensing unit A is marked as $ADC\_OUT_{1A}$ and slope represents an scale factor, then:

$$slope_1 = \frac{\Delta V_{SET1}}{T_{CLK} * 2^N} = \frac{V_{INXA}}{ADC\_OUT_{1A}}$$

$$\Rightarrow$$

$$ADC\_OUT_{1A} = \frac{V_{INXA} * T_{CLK} * 2^N}{\Delta V_{SET1}} \qquad (1)$$

In addition, for a fingerprint sensing unit B adjacent to the fingerprint sensing unit A, a signal obtained after subsequent signal amplification and enhancement of the fingerprint information sensed by the fingerprint sensing unit B is marked as $V_{INXB}$, and a digital codeword obtained after an analog-to-digital conversion of the fingerprint information sensed by the fingerprint sensing unit B is marked as $ADC\_OUT_{1B}$.

$$slope_1 = \frac{\Delta V_{SET1}}{T_{CLK} * 2^N} = \frac{V_{INXB}}{ADC\_OUT_{1B}}$$

$$\Rightarrow$$

$$ADC\_OUT_{1B} = \frac{V_{INXB} * T_{CLK} * 2^N}{\Delta V_{SET1}} \qquad (2)$$

As known from the above relationships (1) and (2), a digital codeword difference obtained after the fingerprint information sensed by the adjacent fingerprint sensing units A and B is quantized is:

$$\Delta ADC\_OUT_1 = ADC\_OUT_{1A} - ADC\_OUT_{1B}$$

$$= (V_{INXA} - V_{INXB}) * \frac{T_{CLK} * 2^N}{\Delta V_{SET1}} \qquad (3)$$

Assume that during acquisition of the second frame of fingerprint information, the finger press action is not changed, and the output range of the quantized voltage of the ramp generator in the ramp analog-to-digital converter is adjusted to $\Delta V_{SET2}$, then the signal obtained after subsequent signal amplification and enhancement of the fingerprint information sensed by the fingerprint sensing unit A is still marked as $V_{INXA}$, and the digital codeword obtained after an analog-to-digital conversion of the fingerprint information sensed by the fingerprint sensing unit A is marked as $ADC\_OUT_{2A}$, then:

$$slope_2 = \frac{\Delta V_{SET2}}{T_{CLK} * 2^N} = \frac{V_{INXA}}{ADC\_OUT_{2A}}$$

$$\Rightarrow$$

$$ADC\_OUT_{2A} = \frac{V_{INXA} * T_{CLK} * 2^N}{\Delta V_{SET2}} \qquad (4)$$

In addition, for a fingerprint sensing unit B adjacent to the fingerprint sensing unit A, a signal obtained after subsequent signal amplification and enhancement of the fingerprint information sensed by the fingerprint sensing unit B is marked as $V_{INXB}$, and a digital codeword obtained after an analog-to-digital conversion of the fingerprint information sensed by the fingerprint sensing unit B is marked as $ADC\_OUT_{2B}$.

$$slope_2 = \frac{\Delta V_{SET2}}{T_{CLK} * 2^N} = \frac{V_{INXB}}{ADC\_OUT_{2B}}$$

$$\Rightarrow$$

$$ADC\_OUT_{2B} = \frac{V_{INXB} * T_{CLK} * 2^N}{\Delta V_{SET2}}$$ (5)

As known from the above relationships (3) and (4), a digital codeword difference obtained after the fingerprint information sensed by the adjacent fingerprint sensing units A and B is quantized is:

$$\Delta ADC\_OUT_2 = ADC\_OUT_{2A} - ADC\_OUT_{2B}$$

$$= \left(V_{INXA} - V_{INXB}\right) * \frac{T_{CLK} * 2^N}{\Delta V_{SET2}}$$ (6)

Assume that the relationship $\Delta V_{SET1} = 4\Delta V_{SET2}$ (7) is established,

then as known from relationships (3), (6) and (7), $\dfrac{\Delta ADC\_OUT_2}{\Delta ADC\_OUT_1} = 4$ , that is, with the adjustment of the quantized voltage range of the ramp generator, a quantized DPI of the analog-to-digital conversion of the fingerprint image may be significantly improved, and thus the contrast of fingerprint gray information is improved.

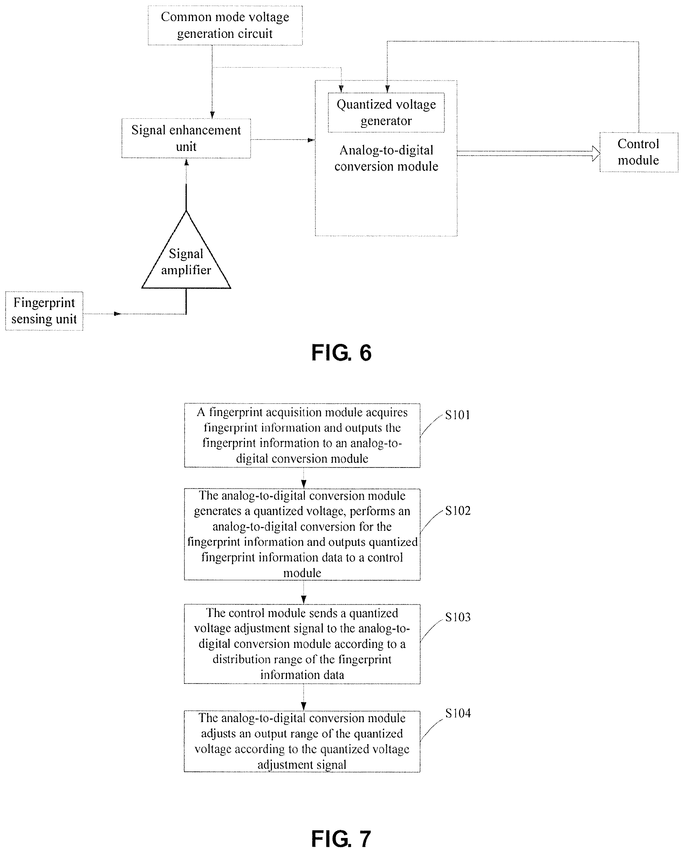

Referring to FIG. 5 and FIG. 6, a second embodiment of the present invention provides a fingerprint identification apparatus. This embodiment differs from the first embodiment in that a common mode voltage generation circuit is added, wherein the common mode voltage generation circuit is respectively connected to the fingerprint acquisition module and the analog-to-digital conversion module, and is configured to coordinate a common mode level of an output signal of the fingerprint acquisition module with a common mode level of an input signal of the analog-to-digital conversion module by the common mode voltage generation circuit, such that the analog-to-digital conversion module operates in an optimal state.

FIG. 6 illustrates a schematic circuit diagram of the fingerprint identification apparatus according to this embodiment. The fingerprint sensing unit, the signal amplifier, the signal enhancement unit, the analog-to-digital conversion module and the control module are sequentially connected; and the common mode voltage generation circuit is respectively connected to the signal enhancement unit of the fingerprint acquisition module and the analog-to-digital conversion module. Under coordination of the reference voltage signal output by the common mode voltage generation circuit, a common mode level Vcom of a fingerprint detection signal output by the signal enhancement unit is substantially equal to a common mode level Vcmi of an input signal of the analog-to-digital conversion module, such that the swing of the fingerprint detection signal output by the signal enhancement unit reaches a maximum signal swing and the signal swing does not exceed but is closest to the size of an adjusted quantization window.

With the fingerprint identification apparatus according to the present invention, during fingerprint information sensing or detection, the voltage of the quantized voltage of the analog-to-digital converter is adjusted according to the distribution range of a current frame of fingerprint information data, to thus increase the distribution range of a next frame of fingerprint information data, thereby achieving dynamic adjustment of the contrast of the fingerprint image. By improving dots per inch of analog-to-digital conversion of the fingerprint information, the contrast and signal-to-noise ratio of gray information of the fingerprint image are improved. In addition, the common mode voltage generation circuit coordinates a common mode level of the output signal of the signal enhancement unit of the fingerprint acquisition module with a common mode level of the input signal of the analog-to-digital conversion module, such that the swing of a fingerprint detection signal reaches a maximum signal swing and the signal swing does not exceed but is closest to the size of an adjusted quantization window, and such that the analog-to-digital conversion module operates in an optimal state. The fingerprint identification apparatus according to the present invention increases the proportion of differential information between "ridges" and "valleys" in the quantized data of the fingerprint information. To be specific, the contrast of "ridges" and "valleys" images is enhanced, the imaging quality is notably improved, and finally the identification rate of subsequent fingerprint identification is improved.

Accordingly, the fingerprint identification apparatus according to the present invention has the following advantages:

First, the circuit is simple and the implementation cost is low, and since the implementation form and operating state of the fingerprint sensing unit are not changed, the imaging consistency is ensured.

Second, no dielectric layer having special properties is needed, and the adaptability of the sensor is improved.

Third, the adjustment of the quantized voltage is associated with the distribution of the fingerprint information data, dynamic adjustment may be achieved, the adjustment is relatively flexible, and the interference to common mode information between the "ridges" and "valleys" may be prevented to the greatest extent.

Fourth, any analog-to-digital converter structure may be implemented, and therefore the adaptability is good.

Fifth, the processing speed is high, and thus the imaging frame rate of the fingerprint identification apparatus may not be lowered.

Referring to FIG. 7, a first embodiment of a fingerprint identification method of the present invention is provided, wherein the fingerprint identification method comprises the following steps:

Step S101: A fingerprint acquisition module acquires fingerprint information and outputs the fingerprint information to an analog-to-digital conversion module.

The fingerprint acquisition module comprises a fingerprint sensing unit, a signal amplifier and a signal enhancement unit (or referred to as a noise shaping and signal enhancement unit) that are sequentially connected. The fingerprint sensing unit acquires fingerprint information. The signal amplifier amplifies the collected fingerprint information. The signal enhancement unit performs noise shaping, signal-to-noise ratio enhancement or the like, and outputs the processed fingerprint information to the analog-to-digital conversion module.

Step S102: The analog-to-digital conversion module generates a quantized voltage to perform an analog-to-digital conversion for the fingerprint information and outputs quantized fingerprint information data to a control module.

The analog-to-digital conversion module generates a quantized voltage by using a quantized voltage generator. The analog-to-digital conversion process is also a quantization process, and a signal output by the quantized voltage generator may be a single-ended signal, or may be a differential signal. Preferably, the analog-to-digital module may be a ramp analog-to-digital converter, a pipelined analog-to-digital converter or a successive approximation analog-to-digital converter. The ramp analog-to-digital converter is preferably selected. In this case, the quantized voltage generator is correspondingly a ramp generator. The ramp analog-to-digital converter has a small area, which may be simply practiced and has good linearity.

Step S103: The control module sends a quantized voltage adjustment signal to the analog-to-digital conversion module according to a distribution range of the fingerprint information data.

To be specific, the control module performs the algorithm-based processing for the fingerprint information according to the distribution characteristics of the currently received fingerprint information data such as the distribution range or the like, and outputs a control signal to the quantized voltage generator of the analog-to-digital conversion module.

Step S104: The analog-to-digital conversion module adjusts an output range of the quantized voltage according to the quantized voltage adjustment signal.

To be specific, the quantized voltage generator of the analog-to-digital conversion module generates a corresponding quantized reference voltage according to the control signal, and adjusts the output range of the quantized voltage. As such, FS and LSB of the analog-to-digital converter may be dynamically changed, and finally the dynamic adjustment function of the contrast of the fingerprint image may be implemented in the fingerprint identification apparatus. The FS refers to an amplitude of an effective full swing input signal, and LSB refers to a least significant bit output by the analog-to-digital converter, which is equal to $FS/2^N$, wherein N represents the number of bits of the analog-to-digital converter.

Accordingly, the range of the quantized voltage is negatively correlated to the distribution range of the fingerprint information data, and the distribution range of the fingerprint information may be increased by narrowing the range of the quantized voltage by a specific amplitude, to further improve the contrast of the fingerprint image. If the output range of the quantized voltage of the quantized voltage generator in the analog-to-digital conversion module is narrowed to $1/X$ of the original range, the contrast of the obtained second frame of fingerprint information is improved to $\log_2(X)$ times the contrast of the first frame of fingerprint information. Generally, the signal-to-noise ratio is also accordingly improved to $\log_2(X)$ times that of the first frame. Therefore, the imaging quality is significantly optimized.

As such, the fingerprint identification method according to the present invention increases the proportion of differential information between "ridges" and "valleys" in the quantified data of the fingerprint information. To be specific, the contrast of "ridges" and "valleys" images is enhanced, the imaging quality is notably improved, and finally the identification rate of subsequent fingerprint identification is improved.

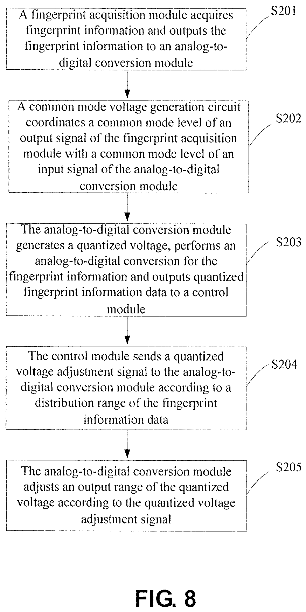

Referring to FIG. 8, a second embodiment of the fingerprint identification method of the present invention is provided, wherein the fingerprint identification method comprises the following steps:

Step S201: A fingerprint acquisition module acquires fingerprint information and outputs the fingerprint information to an analog-to-digital conversion module.

Step S202: A common mode voltage generation circuit coordinates a common mode level of an output signal of the fingerprint acquisition module with a common mode level of an input signal of the analog-to-digital conversion module.

In this embodiment, a common mode voltage generation circuit is additionally arranged, wherein the common mode voltage generation circuit is respectively connected to the signal enhancement unit of the fingerprint acquisition module and the analog-to-digital conversion module. Under coordination of the reference voltage signal output by the common mode voltage generation circuit, a common mode level $V_{com}$ of a fingerprint detection signal output by the signal enhancement unit is substantially equal to a common mode level $V_{cmi}$ of an input signal of the analog-to-digital conversion module, such that the swing of the fingerprint detection signal output by the signal enhancement unit reaches a maximum signal swing and the signal swing does not exceed but is closest to the size of an adjusted quantization window, and such that the analog-to-digital conversion module operates in an optimal state.

Step S203: The analog-to-digital conversion module generates a quantized voltage to perform an analog-to-digital conversion for the fingerprint information and outputs quantized fingerprint information data to a control module.

Step S204: The control module sends a quantized voltage adjustment signal to the analog-to-digital conversion module according to a distribution range of the fingerprint information data.

Step S205: The analog-to-digital conversion module adjusts an output range of the quantized voltage according to the quantized voltage adjustment signal.

With the fingerprint identification method according to the present invention, during fingerprint information sensing or detection, the voltage of the quantized voltage of the analog-to-digital converter is adjusted according to the distribution range of a current frame of fingerprint information data, to thus increase the distribution range of a next frame of fingerprint information data, thereby achieving dynamic adjustment of the contrast of the fingerprint image. By improving dots per inch of analog-to-digital conversion of the fingerprint information, the contrast and signal-to-noise ratio of gray information of the fingerprint image are improved. In addition, the common mode voltage generation circuit coordinates a common mode level of the output signal of the signal enhancement unit of the fingerprint acquisition module with a common mode level of the input signal of the analog-to-digital conversion module, such that the swing of a fingerprint detection signal reaches a maximum signal swing and the signal swing does not exceed but is closest to the size of an adjusted quantification window, and such that the analog-to-digital conversion module operates in an optimal state.

The fingerprint identification method according to the present invention increases the proportion of differential information between "ridges" and "valleys" in the quantified data of the fingerprint information. To be specific, the contrast of "ridges" and "valleys" images is enhanced, the imaging quality is notably improved, and finally the identification rate of subsequent fingerprint identification is improved.

It should be noted that the fingerprint identification method provided in the above embodiment is based on the same inventive concept as the fingerprint identification apparatus embodiment, and the technical features in the method embodiments are correspondingly applicable to the apparatus embodiments, which is thus not described herein any further.

It is understandable to those skilled in the art that all or partial steps of the method described in the above embodiments can be implemented by controlling relevant hardware by programs. The programs may be stored in a computer readable storage medium. The storage medium may be a read only memory (ROM), random access memory (RAM), a magnetic disk or a compact disc read-only memory (CD-ROM).

It should be understood that described above are merely exemplary embodiments of the present invention, but are not intended to limit the scope of the present invention. Any equivalent structure or equivalent process variation made based on the specification and drawings of the present invention, which is directly or indirectly applied in other related technical fields, fall within the scope of the present invention.

## Industrial Practicability

According to the fingerprint identification apparatus and method provided by the present invention, a quantized voltage range of the analog-to-digital converter is adjusted according to currently received fingerprint information data, and a distribution range of subsequent fingerprint information data is enlarged, thereby achieving dynamic adjustment of the contrast of a fingerprint image. By improving dots per inch of analog-to-digital conversion of the fingerprint information, the contrast and signal-to-noise ratio of gray information of the fingerprint image are improved. In addition, the common mode voltage generation circuit coordinates a common mode level of the output signal of the signal enhancement unit of the fingerprint acquisition module with a common mode level of the input signal of the analog-to-digital conversion module, such that the swing of a fingerprint detection signal reaches a maximum signal swing and the signal swing does not exceed but is closest to the size of an adjusted quantification window, and such that the analog-to-digital conversion module operates in an optimal state. The fingerprint identification apparatus according to the present invention increases the proportion of differential information between "ridges" and "valleys" in the quantized data of the fingerprint information, To be specific, the contrast of "ridges" and "valleys" images is enhanced, the imaging quality is notable improved, and finally the identification rate of subsequent fingerprint identification is improved.

The fingerprint identification apparatus according to the present invention has the following advantages: The circuit is simple and the implementation cost is low, and since the implementation form and operating state of the fingerprint sensing unit are not changed, the imaging consistency is ensured; no dielectric layer having special properties is needed, and the adaptability of the sensor is improved; the adjustment of the quantized voltage is associated with the distribution of the fingerprint information data, dynamic adjustment may be achieved, the adjustment is relatively flexible, and the interference to common mode information between the "ridges" and "valleys" may be prevented to the greatest extent; any analog-to-digital converter structure may be implemented, and therefore the adaptability is good; and the processing speed is high, and thus the imaging frame rate of the fingerprint identification apparatus may not be lowered.

**Claims**

1. A fingerprint identification apparatus, comprising a fingerprint acquisition module, an analog-to-digital conversion module and a control module that are sequentially connected, the analog-to-digital conversion module comprises a quantized voltage generator for generating a quantized voltage, the fingerprint acquisition module is configured to acquire fingerprint information, and the analog-to-digital conversion module is configured to perform an analog-to-digital conversion for the fingerprint information and output quantized fingerprint information data; wherein the control module is configured to control the quantized voltage generator to adjust an output range of the quantized voltage according to a distribution range of the fingerprint information data to enlarge a distribution range of the quantized fingerprint information data.

2. The fingerprint identification apparatus according to claim 1, further comprising a common mode voltage generation circuit respectively connected to the fingerprint acquisition module and the analog-to-digital conversion module, wherein the common mode voltage generation circuit is configured to coordinate a common mode level of an output signal of the fingerprint acquisition module with a common mode level of an input signal of the analog-to-digital conversion module.

3. The fingerprint identification apparatus according to claim 1 or 2, wherein the fingerprint acquisition module comprises a fingerprint sensing unit, a signal amplifier and a signal enhancement unit that are sequentially connected, wherein the signal enhancement unit is connected to the analog-to-digital conversion module.

4. The fingerprint identification apparatus according to claim 1 or 2, wherein the analog-to-digital module is a ramp analog-to-digital converter, and the quantized voltage generator is a ramp generator.

5. The fingerprint identification apparatus according to claim 1 or 2, wherein the quantized voltage generator outputs a single-end signal or a differential signal.

6. The fingerprint identification apparatus according to claim 1 or 2, wherein the analog-to-digital module is a pipelined analog-to-digital converter or a successive approximation analog-to-digital converter.

7. A fingerprint identification method, comprising:

   acquiring fingerprint information and outputting the fingerprint information by a fingerprint acquisition module to an analog-to-digital conversion module;
   generating a quantized voltage to perform an analog-to-digital conversion for the fingerprint information and outputting quantized fingerprint information data by the analog-to-digital conversion module to a control module;
   sending a quantized voltage adjustment signal by the control module to the analog-to-digital conversion module according to a distribution range of the fingerprint information data; and
   adjusting an output range of the quantized voltage by the analog-to-digital conversion module according to the quantized voltage adjustment signal.

8. The fingerprint identification method according to claim 7, wherein while the fingerprint acquisition module outputs the fingerprint information to the analog-to-digital conversion module, the method further comprises:

   coordinating a common mode level of an output signal of the fingerprint acquisition module with a common mode level of an input signal of the analog-to-digital conversion module by a common mode voltage generation circuit.

9. The fingerprint identification method according to claim 7 or 8, wherein the analog-to-digital conversion module generates the quantized voltage by using a quantized voltage generator.

10. The fingerprint identification method according to claim 7 or 8, wherein the analog-to-digital module is a ramp analog-to-digital converter, a pipelined analog-to-digital converter or a successive approximation analog-to-digital converter.

Fingering identification
apparatus

Fingerprint acquisition
module

Analog-to-digital
conversion module

Control module

**FIG. 1**

Fingerprint
acquisition module

Fingerprint sensing unit

Signal amplifier

Signal enhancement unit

**FIG. 2**

**FIG. 3**

**FIG. 4**

**FIG. 5**

Common mode voltage
generation circuit

Quantized voltage
generator

Control
module

Signal enhancement
unit

Analog-to-digital
conversion module

Signal
amplifier

Fingerprint
sensing unit

# FIG. 6

A fingerprint acquisition module acquires
fingerprint information and outputs the
fingerprint information to an analog-to-
digital conversion module

S101

The analog-to-digital conversion module
generates a quantized voltage, performs an
analog-to-digital conversion for the
fingerprint information and outputs quantized
fingerprint information data to a control
module

S102

The control module sends a quantized
voltage adjustment signal to the analog-to-
digital conversion module according to a
distribution range of the fingerprint
information data

S103

The analog-to-digital conversion module
adjusts an output range of the quantized
voltage according to the quantized voltage
adjustment signal

S104

# FIG. 7

A fingerprint acquisition module acquires fingerprint information and outputs the fingerprint information to an analog-to-digital conversion module ⟋ S201

↓

A common mode voltage generation circuit coordinates a common mode level of an output signal of the fingerprint acquisition module with a common mode level of an input signal of the analog-to-digital conversion module ⟋ S202

↓

The analog-to-digital conversion module generates a quantized voltage, performs an analog-to-digital conversion for the fingerprint information and outputs quantized fingerprint information data to a control module ⟋ S203

↓

The control module sends a quantized voltage adjustment signal to the analog-to-digital conversion module according to a distribution range of the fingerprint information data ⟋ S204

↓

The analog-to-digital conversion module adjusts an output range of the quantized voltage according to the quantized voltage adjustment signal ⟋ S205

# FIG. 8

# INTERNATIONAL SEARCH REPORT

<table>
<tr><td>International application No.</td></tr>
<tr><td>PCT/CN2014/094725</td></tr>
</table>

**A. CLASSIFICATION OF SUBJECT MATTER**

G06K 9/00 (2006.01) i

According to International Patent Classification (IPC) or to both national classification and IPC

**B. FIELDS SEARCHED**

Minimum documentation searched (classification system followed by classification symbols)

G06K

Documentation searched other than minimum documentation to the extent that such documents are included in the fields searched

Electronic data base consulted during the international search (name of data base and, where practicable, search terms used)

CNTXT DWPI CNKI: fingerprint finger mark identification verification analog-to-digital conversion voltage circuit module image photo gain weight amplification contrast signal-to-noise ratio capacitance

**C. DOCUMENTS CONSIDERED TO BE RELEVANT**

| Category* | Citation of document, with indication, where appropriate, of the relevant passages | Relevant to claim No. |
|---|---|---|
| X | CN 102279924 A (JINPENG SCI&TECHNOLOGY CO LTD) 14 December 2011 (14.12.2011) description, paragraphs [0028]-[0035] and fig. 2 | 1,7,9 |
| A | CN 102279924 A (JINPENG SCI&TECHNOLOGY CO LTD) 14 December 2011(14.12.2011) the whole document | 2-6,8,10 |
| A | CN 1290383 A (QUALCOMM INC) 04 April 2001(04.04.2001) the whole document | 1-10 |
| A | US 2007/0164115 A1 (SYMBOL TECHNOLOGIES INC) 19 July 2007(19.07.2007) the whole document | 1-10 |
| A | US 2007/0092117 A1(QI B)26 April 2007(26.04.2007) the whole document | 1-10 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 08 June 2015 | 16 June 2015 |

| Name and mailing address of the ISA State Intellectual Property Office of the P. R. China No. 6, Xitucheng Road, Jimenqiao Haidian District, Beijing 100088, China Facsimile No. (86-10) 62019451 | Authorized officer DONG, Gang Telephone No. (86-10) 62411766 |

Form PCT/ISA /210 (second sheet) (July 2009)

## INTERNATIONAL SEARCH REPORT
Information on patent family members

International application No.

PCT/CN2014/094725

| Patent Documents referred in the Report | Publication Date | Patent Family | Publication Date |
|---|---|---|---|
| CN 102279924 A | 14 December 2011 | None | |
| CN 1290383 A | 04 April 2001 | JP4129892B2 | 06 August 2008 |
| | | JP2002502520A | 22 January 2002 |
| | | EP0985196B9 | 02 May 2003 |
| | | DE69809907D1 | 16 January 2003 |
| | | KR20010012635A | 26 February 2001 |
| | | EP0985196B1 | 04 December 2002 |
| | | WO9852157A1 | 19 November 1998 |
| | | EP0985196A1 | 15 March 2000 |
| | | US6259804B1 | 10 July 2001 |
| | | AU7371598A | 08 December 1998 |
| US 2007/0164115 A1 | 19 July 2007 | WO2007111761A2 | 19 July 2007 |
| | | WO2007111761A3 | 28 August 2008 |
| US 2007/0092117 A1 | 26 April 2007 | US 7965877B2 | 21 June 2011 |

Form PCT/ISA /210 (patent family annex) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 200510063872